# EUROPEAN PATENT APPLICATION

(11) **EP 2 455 506 A1**
(43) Date of publication of application: **23.05.2012**
(21) Application number: 10799828.8
(22) Date of filing: 13.07.2010
(51) Int. Cl.: C22C 38/00, C22C 38/22, C22C 38/60, C23C 14/06

(54) **COATED-SURFACE SLIDING PART HAVING EXCELLENT COATING ADHESION AND METHOD FOR PRODUCING THE SAME**

(30) Priority: 15.07.2009 JP 2009166778
(71) Applicant: Hitachi Tool Engineering, Ltd., Tokyo 105-8614 (JP); Hitachi Metals, Ltd., Tokyo 105-8614 (JP)
(72) Inventor: HONDA Fumiaki, Matsue-shi Shimane 690-0816 (JP); YOKOYAMA Kenji, Yasugi-shi Shimane 692-8601 (JP); INOUE Kenichi, Matsue-shi Shimane 690-0816 (JP); KUBOTA Kunichika, Yasugi-shi Shimane 692-8601 (JP); UEHARA Toshihiro, Yasugi-shi Shimane 692-8601 (JP); OHNO Takehiro, Yasugi-shi Shimane 692-8601 (JP); OHISHI Katsuhiko, Yasugi-shi Shimane 692-8601 (JP)
(74) Representative: Strehl Schübel-Hopf & Partner
(86) International application number: PCT/JP2010/061812
(87) International publication number: WO 2011/007770

(57) **Abstract**

Provided is a coated-surface sliding part having excellent adhesion of a hard coating, and a method for producing the same part. The coated-surface sliding part is a sliding part wherein a hard coating is formed by physical deposition on the surface of a base material formed from, by mass percent, C 0.5 to 0.8%, Si 0.1 to 1.5%, Mn 0.2 to 1.0%, Cr 8.0 to 13.5%, Mo and/or W 0.5 to 4.0% in terms of (Mo+1/2W), and N 0.01 to 0.1%, with the remainder being Fe and impurities. The physically deposited coating is a titanium metal coating further covered by a diamond-like carbon coating. The method for producing a coated-surface part involves sputtering in order to apply the physically deposited coating, which consists of the titanium metal coating and then the diamond-like carbon coating which forms the surface layer, to the surface of the base material having the aforementioned composition. The base material is preferably subjected to argon gas bombardment prior to application of the physically deposited coating.

## Description

### Technical Field

The present invention relates to various kinds of sliding components having a surface coated with a hard film, which can be used for mechanical apparatuses, automobiles and the like, and a method for producing the same.

### Background Art

Since a component formed by coating the surface of a metallic base material with a hard film such as a diamond-like carbon (hereinafter sometimes referred to as DLC) film or a ceramic film is able to improve properties such as abrasion resistance and slidability, it has been applied as a sliding component that is used in a severe environment. Among others, a sliding component that is coated with a DLC film having a Vickers hardness from 2000 HV to 3000 HV or more is excellent in abrasion resistance and slidability, and thus, it has been widely used.

Representative methods for forming a DLC film include a chemical vapor deposition (hereinafter sometimes referred to as CVD) method and a physical vapor deposition (hereinafter sometimes referred to as PVD method). However, in the case of the CVD method in which the temperature reaches 1000°C or higher during the coating operation, a base material tends to be significantly deformed. In particular, in the case of using a steel base material including a tool steel as a typical example, which is most suitable for the technical field of the present case, the CVD method is problematic in terms of heat treatment strain caused by a quenching and tempering heat treatment, which is generally carried out after the coating operation. Accordingly, in the technical field of the present case in which precision is required for the shape of a component itself, it is advantageous to apply the PVD method that is able to form a film at a relatively low temperature and does not require the above described heat treatment after film formation.

However, even in the case of the PVD method, a considerable attention should be paid to the adhesion of a film to a base material. Thus, various methods for improving the adhesion have been proposed. For example, in order to improve the adhesion of a film to a tool steel base material, there has been proposed a method comprising bombarding the surface of the base material with argon gas and then coating it with diamond-like carbon according to a sputtering method (Patent Document 1: JP2005-068499A). With regard to such a bombardment, there has been proposed a method comprising performing a metal bombardment, in which titanium or the like is used as a substance to be applied, and then coating a base material with a DLC film mediated by an intermediate metal film having excellent adhesion to a tool steel base material (Patent Document 2: JP2003-082458A).

Patent Document 1: JP 2005-068499 A
Patent Document 2: JP 2003-082458 A

### Disclosure of Invention

### Problem to be Solved by the Invention

The different bombardments described in Patent Documents 1 and 2 are effective as radical means for improving the adhesion of a physical vapor-deposited film to a base material. In addition to these bombardments, the coating with an intermediate metal film described in Patent Document 2 also exhibits a great effect of further improving the aforementioned adhesion. However, in order to improve coating adhesion of DLC in the field of the PVD method, in addition to the improvement of the "PVD conditions" as described in Patent Documents 1 and 2, improvement of a "base material itself" to be optimal is also effective.

In other words, in the case of coating a base material with a hard film such as a DLC film, even if the base material has high hardness before the coating operation, the base material becomes soft by heating during the coating operation, and as a result, the DLC film can be easily removed. This fact is well known to persons skilled in the art. The PVD method enables a coating treatment at a temperature lower than that of the CVD method, and temperature of the base material is approximately 200°C when a DLC film is formed. If the above described bombardment is performed on this base material, the temperature thereof reaches 300°C or higher during the bombardment operation. Further, if a metal bombardment having high collision energy is performed on the base material, the temperature thereof reaches 400°C or higher. Accordingly, a material that hardly becomes soft even at a high temperature of 500°C and specifically maintains a high Rockwell hardness of 58 HRC or more has been required as a base material during the above described bombardment.

In Patent Document 1 that mainly targets cutting tools, since a high-speed tool steel used as a base material contains large amounts of alloy elements such as Mo, W, V and Nb, hardness of the base material is kept high during formation of a PVD film. However, while such a high-speed tool steel requires addition of large amounts of expensive alloy elements, it has insufficient corrosion resistance. Accordingly, its usage environment is limited, and thus, the high-speed tool steel has been considered to be a base material that requires radical improvement in the technical field of the present case.

Hence, it is an object of the present invention to provide a sliding component that achieves excellent coating adhesion even in a case where a metal bombardment is performed during coating of a base material with a DLC film according to the PVD method.

### Means for Solving the Problem

The present inventors have conducted intensive studies directed toward providing a surface-coated sliding component having excellent coating adhesion. As a result, the inventors have found that the above described method of coating a base material with an intermediate metal film should be performed before the base material is coated with a DLC film by PVD method. They have also found that it is effective to perform a metal bombardment on the base material before the aforementioned coating operation. Thus, the inventors have discovered a base material maintaining high adhesion strength, which maintains high hardness irrespective of whether a metal bombardment is performed or not; namely, preferably maintains an adjustment hardness of 58 HRC or more even under a high-temperature treatment at 500°C or higher. Thereby, they have completed a surface-coated sliding component of the present invention. Moreover, the inventors have found that there are special and effective combination conditions between the above described metal bombardment and the subsequent method of coating a base material with an intermediate film. By specifying such pre-film-formation treatment conditions, the inventors have completed a method of the present invention for producing a surface-coated sliding component, by which, in particular, adhesion of a hard film can be significantly improved.

Specifically, the present invention relates to a surface-coated sliding component having excellent coating adhesion, wherein the surface of a base material comprising, in % by mass, C: 0.5% to 0.8%, Si: 0.1% to 1.5%, Mn: 0.2% to 1.0%, Cr: 8.0% to 13.5%, Mo and/or W: 0.5% to 4.0% (in terms of Mo + 1/2 W), N: 0.01% to 0.1%, and the balance consisting of Fe and impurities, is coated with a hard physical vapor-deposited film, wherein the physical vapor-deposited film comprises a titanium metal film and a diamond-like carbon film further coating the titanium metal film. The base material preferably comprises Cr: 9.0% to 11.0%. In addition, the base material preferably comprises one or more of S: 0.1% or less, Ca: 0.1% or less, and Mg: 0.03% or less, or further, it preferably comprises one or more of V: 1.0% or less, Nb: 0.3% or less, Ni: 1.0% or less, and Cu: 0.5% or less.

The base material desirably has a hardness of 58 HRC or more. The above described physical vapor-deposited film desirably comprises the diamond-like carbon film having a surface hardness of 1000 HV or more. Moreover, the physical vapor-deposited film desirably comprises, between the titanium metal film and the diamond-like carbon film, a mixed gradient film consisting of titanium and carbon, in which titanium content gradually decreases toward the side of the diamond-like carbon film.

Also, the present invention relates to a method for producing a surface-coated sliding component, wherein the surface of a base material comprising, in % by mass, C: 0.5% to 0.8%, Si: 0.1% to 1.5%, Mn: 0.2% to 1.0%, Cr: 8.0% to 13.5%, Mo and/or W: 0.5% to 4.0% (in terms of Mo + 1/2 W), N: 0.01% to 0.1%, and the balance consisting of Fe and impurities, is coated with a hard physical vapor-deposited film, the method comprising coating the base material with a titanium metal film and then with a diamond-like carbon film as a surface layer according to a sputtering method, whereby the base material is coated with the physical vapor-deposited film comprising the titanium metal film and the diamond-like carbon film. An argon gas bombardment is desirably performed on the base material, before the base material is coated with the physical vapor-deposited film.

Moreover, it is desirable that, before the base material is coated with the physical vapor-deposited film, a titanium metal ion bombardment according to an arc ion plating method be performed on the base material, and subsequently, the base material be coated with the physical vapor-deposited film. It is further desirable that an argon gas bombardment be performed on the base material, before the titanium metal ion bombardment is performed thereon. After completion of the titanium metal ion bombardment, the treated base material is preferably subsequently coated with the physical vapor-deposited film according to the sputtering method, in a state where the base material is kept in a treating chamber.

The base material preferably comprises Cr: 9.0% to 11.0%. In addition, the base material preferably comprises one or more of S: 0.1% or less, Ca: 0.1% or less, and Mg: 0.03% or less, or further, it preferably comprises one or more of V: 1.0% or less, Nb: 0.3% or less, Ni: 1.0% or less, and Cu: 0.5% or less. Moreover, the base material desirably has an adjustment hardness of 58 HRC or more.

The physical vapor-deposited film desirably comprises the diamond-like carbon film having a surface hardness of 1000 HV or more. Furthermore, the coating of the physical vapor-deposited film is desirably performed according to an unbalanced magnetron sputtering method. Further, the coating of a mixed gradient film consisting of titanium and carbon may be performed between the titanium metal film and the diamond-like carbon film, the mixed gradient film having titanium content which gradually decreases toward the side of the diamond-like carbon film.

### Advantages of the Invention

According to the present invention, because a base material maintains high hardness even in a case in which a metal bombardment is performed on the base material, before it is coated with a DLC film by physical vapor deposition, it becomes possible to provide a sliding component having excellent coating adhesion.

### Brief Description of the Drawings

[Fig. 1] Fig. 1 is a microphotograph of an indentation on the film of sample No. 17 as an example of the present invention in a coating adhesion test carried out in Examples.
[Fig. 2] Fig. 2 is a microphotograph of an indentation on the film of sample No. 18 as an example of the present invention in a coating adhesion test carried out in Examples.
[Fig. 3] Fig. 3 is a microphotograph of an indentation on the film of sample No. 6 as a comparative example in a coating adhesion test carried out in Examples.

### Best Mode for Carrying Out the Invention

### [Surface-coated sliding component of the present invention]

The physical vapor-deposited film comprised in the surface-coated sliding component of the present invention is **characterized in that** an intermediate film of titanium metal is applied below a DLC film. That is to say, hardness of the DLC film as a hard film reaches approximately 1000 HV or more, further 1500 HV or more, and still further 2000 HV or more. Accordingly, deterioration in adhesion strength caused by internal stress of a film easily occurs between the base material and the DLC film. Thus, in the present invention, as a radical means for reducing this stress difference, a titanium metal film is disposed between the base material and the DLC film. Because this intermediate metal film has low hardness as compared with the DLC film, it is possible to buffer the stress difference generated between the base material and the DLC film. Because such a titanium metal film has high adhesion to a base material made of metal and has a moderate hardness of approximately 200 to 300 HV, it is excellent in terms of the above described effect of buffering stress. Moreover, the titanium metal film has high action to complement oxygen during the coating operation, and thus it is a preferred metal species.

A bombardment, which is performed on a base material as a pre-treatment before the base material is coated with a DLC film according to PVD method, has action to clean the surface of the base material, and thus, this treatment is effective for improvement in coating adhesion. However, if hardness of the base material excessively decreases due to temperature rise during the bombardment, it results in deterioration of coating adhesion. That is, final usage hardness of a PVD-coated component is generally adjusted at the stage of the base material before the coating treatment. If the component is made of steel, hardness adjustment is carried out by a quenching and tempering heat treatment. If target adjustment hardness becomes 58 HRC or more, tempering temperature region that can achieve such hardness ranges from a low temperature of approximately 100°C to a high temperature of 500°C or higher, and thus, it varies depending on the type of the steel. Accordingly, if it is a steel which tempering temperature achieving the aforementioned hardness of 58 HRC or more is, for example, approximately 200°C, even if the steel is adjusted to the target hardness of 58 HRC or more before a PVD-coating treatment, temperature of the base material increases during the subsequent bombardment. If the temperature largely exceeds the tempering temperature, the base material becomes soft.

Hence, one feature of the present invention is a base material whose hardness is hardly affected by the above-mentioned bombardment. That is, while a high adjustment hardness, such as specifically 58 HRC or more, further 59 HRC or more, and still further 60 HRC or more, is achieved, such a high adjustment hardness can be stably obtained at a high tempering temperature. Thus, the present base material has an alloy composition that can maintain the aforementioned hardness even at a high temperature of 500°C for a metal bombardment. In addition, this novel base material is inexpensive as compared with conventional high-speed tool steels and has excellent corrosion resistance. Thus, this base material is used to provide a sliding component that can be sufficiently used under a high corrosion environment caused by machine oil or the like. The composition of ingredients of the base material will be explained below.

### C: 0.5% to 0.8% by mass (hereinafter simply referred to as %)

C is an element that can enhance hardness of a base material and form a carbide with Cr, Mo or W as a result of high temperature tempering, so as to ensure abrasion resistance of the base material. However, if the amount of C is too large, it may reduce toughness of the base material. Moreover, if the amount of solid solution Cr in the base material decreases due to the formation of a carbide, corrosion resistance may also deteriorate. In contrast, if the amount is too small, the aforementioned addition effect cannot be obtained. Accordingly, the amount of C is limited to 0.5% to 0.8%. A preferred lower limit is 0.55%, and more preferably 0.6%. A preferred upper limit is 0.75%, and more preferably 0.7%.

### Si: 0.1% to 1.5%

Si is an element that is added as a deoxidizing element and can enhance hardness during high temperature tempering in the present invention. However, even if Si is excessively added, the improvement of the aforementioned effect hits a peak, and rather it may inhibit toughness or hot workability. Accordingly, the amount of Si is set at 0.1% to 1.5%. A preferred lower limit is 0.4%, more preferably 0.6%, and further preferably 0.8%. A preferred upper limit is 1.3%, and more preferably 1.1%.

### Mn: 0.2% to 1.0%

Mn is an element that can increase strength of steel without deterioration of toughness and also improve hardness during high temperature tempering. However, if a base material contains an excessive amount of Mn, it can result in decrease in workability and low temperature toughness. Also, work hardening can easily occur, and during processing, elastic limit, yield point, tensile strength, fatigue limit and the like of a material can increase, and elongation and squeezing may decrease. Moreover, it may cause embrittlement during tempering. Accordingly, the amount of Mn is set at 0.2% to 1.0%. A preferred lower limit is 0.4%, and more preferably 0.6%. A preferred upper limit is 0.8%.

### Cr: 8.0% to 13.5%

Cr can improve quenchability and enhance hardness obtained by high temperature tempering to the maximum by controlling appropriate upper and lower limits. In addition, Cr can also improve corrosion resistance of a base material. Thus, Cr is an important element for enhancing versatility of a sliding component. Since excessive addition of Cr may affect workability and low temperature toughness, the amount of Cr is set at 8.0% to 13.5%. A preferred lower limit is 9.0%. A preferred upper limit is 12.0%, and more preferably 11.0%.

### Mo and/or W: 0.5% to 4.0% (in terms ofMo + 1/2 W)

Mo and W are elements that can improve softening resistance after high temperature tempering by solid solution hardening or precipitation hardening of a carbide, and can also improve abrasion resistance and thermal fatigue resistance. Moreover, they are elements that can form a hard carbide and improve hardness. Mo and W can be added singly or in combination. Since W has an atomic weight that is two times higher than that of Mo, the content thereof can be controlled by the formula (Mo + 1/2 W). If the amounts of Mo and W are too large, it can result in decrease in machinability and deterioration in toughness due to carbide enrichment. Accordingly, in the present invention, the amounts of Mo and/or W are set at 0.5% to 4.0%. A preferred lower limit is 1.0%. A preferred upper limit is 3.0%.

### N: 0.01% to 0.1%

N is an important element that has functions of solid solution hardening and precipitation hardening of a nitride, and action to process crystal grains into fine particles, and can enhance hardness of a base material. Also, N is an element effective for improvement in hardness resulted from high temperature tempering and in creep properties. However, excessive addition ofN can decrease workability and low temperature toughness. Accordingly, the amount ofN is set at 0.01% to 0.1%. A preferred lower limit is 0.03%, and more preferably 0.04%. A preferred upper limit is 0.08%, and more preferably 0.07%.

In addition to the above described elements, S, Ca, Mg, V, Cu, Nb and Ni, which are inevitably mixed into common steel, can be also added to the base material of the present invention, as necessary.

One or more of
S: 0.1% or less,
Ca: 0.1% or less, and
Mg: 0.03% or less.
Since S forms a sulfide with Mn or the like in the base material so as to improve machinability, it can be added, as necessary. However, excessive addition of S can affect hot workability, weld cracking resistance, and corrosion resistance. Thus, even if such S is added, the amount thereof is desirably 0.1% or less. A preferred lower limit is 0.001%, and more preferably 0.004%. A preferred upper limit is 0.08%, and more preferably 0.05%. It is desirable to suppress the amount of S to 0.01% or less, as far as possible.

On the other hand, Ca and Mg are elements that can produce various inclusions or form a sulfide with the above described S so as to improve machinability. Accordingly, as necessary, one or two or more of Ca, Mg and the above described S may be added in combination. When such Ca and Mg are added, the amount of Ca is preferably 0.001% or more, and the amount of Mg is preferably 0.0002% or more. In order to prevent deterioration of toughness and the like due to enrichment of inclusions, it is preferable that the amount of Ca be set at 0.1% or less and the amount of Mg be set at 0.03% or less. Desirably, the amount of Ca may be suppressed to 0.01% or less, and the amount of Mg may be suppressed to 0.005% or less.

One or more of
V: 1.0% or less,
Nb: 0.3% or less,
Ni: 1.0% or less, and
Cu: 0.5% or less.
Other than the above-mentioned elements, one or more of V, Nb, Ni and Cu can also be added as optional elements to the base material of the present invention. Since V has the effect of improving softening resistance and also improving properties such as hardness, strength and toughness, it may be added in an amount range of 1.0% or less. Since Nb has the effect of preventing crystal grains from becoming large ones during high temperature tempering, it may be added in an amount range of 0.3% or less. Since V and Nb are expensive, the use of these elements may be desirably limited within the above described range, regardless of the addition or non-addition thereof. Ni that can improve toughness and hardenability may be added within an amount range of 1.0% or less. Since Cu has the effect of improving corrosion resistance and the like, it may be added within an amount range of 0.5% or less.

Even if the above described base material is heated to a high temperature from 400°C to 500°C, or further higher, it is able to maintain a favorable hardness of 58 HRC or more. Accordingly, for a sliding component whose surface is coated with a DLC film by PVD method, a base material, on which a bombardment is particularly performed before the coating operation, is optimal.

With regard to a physical vapor-deposited film to be coated on this novel base material, it is preferable that a mixed gradient film consisting of titanium and carbon, in which titanium content gradually decreases toward the side of the DLC film, be disposed between the above described titanium metal film and the DLC film. Conventionally, the DLC film is disadvantageous in that it has low adhesion strength because its internal stress is large. Thus, in the present invention, as described above, a titanium metal film is introduced as an intermediate film to alleviate this problem regarding stress. In addition to this, it is desirable to dispose, between the DLC film and the titanium metal film, a mixed gradient film consisting of titanium and carbon, in which titanium content gradually decreases toward the side of the DLC film. Thereby, action to further alleviate stress difference can be obtained, and total adhesion between the base material and the physical vapor-deposited film is improved. Moreover, in this case, since the metal species of this intermediate metal film is a metal that constitutes the gradient film (that is titanium), the total constitution of the film can be easily determined and adjusted.

In order to achieve both the function of a film and adhesion, the above described physical vapor-deposited film of the present invention is desirably controlled to be approximately 0.5 to 3 µm in terms of a total film thickness from the titanium metal film.

### Method for producing a surface-coated sliding component of the present invention

In addition to providing the above described base material for PVD, which is optimal when a bombardment is performed, it is another feature of the present invention to provide optimal conditions for an actual coating treatment with a PVD film, so that a method for producing a surface-coated sliding component having excellent coating adhesion can be established. That is to say, in order to improve the adhesion of a DLC film, a bombardment performed on a base material, which is a pre-coating treatment, is effective. However, formation of an intermediate metal film following the aforementioned bombardment is an essential element (as described above). That is, in the present invention, regardless of the presence or absence of such a bombardment, the base material is coated with an intermediate film consisting of a titanium metal before formation of a DLC film.

In order to obtain a smooth DLC film, it is effective to coat the base material with this titanium metal film according to a sputtering method. That is, when a titanium metal film is formed according to an arc ion plating method, it is disadvantageous that molten particles (droplets) can be easily generated from a titanium metal target acting as a vapor source of the film, and that if such droplets are contained inside the film, surface roughness of the titanium metal film may become high. If the titanium metal film has high surface roughness, the surface roughness of a DLC film that is to be formed thereon also becomes high. As a result, seizure resistance may slightly deteriorate.

After the base material has been coated with the above described titanium metal film, it is then coated with a DLC film according to a sputtering method. By employing the sputtering method, a smooth DLC film having few defects can be formed. Herein, upon coating the base material with a DLC film, it is desirable to adjust a bias voltage applied to the base material during the coating operation. That is, if the bias voltage is set at relatively low (negative pressure) during the coating operation, adhesion is improved as hardness decreases (becomes soft). However, according to the present invention, sufficient coating adhesion has been already achieved by introduction of a titanium metal film and, for example, a combined use of the after-mentioned bombardment. Therefore, sufficient coating adhesion can be maintained, even if the bias voltage is set at relatively high and thus the hardness of the DLC film is increased.

On the other hand, if the above described bias voltage is set at excessively low, it becomes difficult to form the DLC film itself In contrast, if the bias voltage is too high, there is a fear that temperature of the device excessively increases during the coating operation, and defect of the device, deterioration of the film itself, and softening of the base material may occur. Taking into consideration these matters, the bias voltage applied during formation of the DLC film of the present invention is preferably set at approximately -40 to -250 V As a bias voltage applied during formation of the above described titanium metal film, or preferably a mixed gradient film, before formation of the DLC film, the aforementioned bias voltage applied during the formation of the DLC film can be applied without problems.

A physical vapor-deposited film comprising a titanium metal film and a DLC film is preferably formed by an unbalanced magnetron sputtering method among the above described sputtering methods. As a means for coating a base material with a physical vapor-deposited film comprising a DLC film, there has been conventionally applied an unbalanced magnetron sputtering method, which enhances plasma irradiation to the base material by intentionally making magnetic field of a sputtering source unbalance so that it is advantageous in terms of formation of a fine and highly adhesive film. Accordingly, in the present invention as well, the unbalanced magnetron sputtering method can be preferably applied to form a physical vapor-deposited film comprising a titanium metal film and a DLC film. Since the unbalanced magnetron sputtering method enables no generation of molten particles, a smooth film can be formed.

A conventional argon gas bombardment may be performed on the base material, before it is coated with the above described physical vapor-deposited film. When such an argon gas bombardment is performed, bias voltage applied to the base material is desirably set at approximately -100 to -600 V

Moreover, in order to improve the adhesion of a DLC film, when a metal bombardment is performed on the base material before it is coated with the above described physical vapor-deposited film, special and effective combination conditions are necessary between the metal bombardment and the subsequent formation of an intermediate metal film. Namely, before formation of the DLC film, a titanium metal ion bombardment is performed on the base material according to an arc ion plating method, and thereafter, an intermediate film comprising a titanium metal is formed thereon according to a sputtering method.

If the base material, which is not yet coated with the physical vapor-deposited film of the present invention including the above described intermediate metal film, is pretreated only by an argon gas bombardment, a large amount of oxygen is generated at the interface between the film and the base material in some cases, and it results in poor adhesion. This oxygen generated at the interface is mainly caused by an oxidized film that has been originally formed on the surface of the base material, and thus, it is a remaining element that is hardly removed by the argon gas bombardment.

In contrast, since specific gravity of the ionic element resulted from the metal ion bombardment of the present invention is greater than that resulted from the argon gas bombardment, it causes high collision energy, and the oxidized film on the surface of the base material is easily removed. In addition, by applying an arc ion plating method instead of a sputtering method, naturally, the amount of ion generated that is to come into collision with the base material significantly increases. Thereby, the ability to remove the oxidized film from the surface of the base material is improved, and the effect of increasing the adhesion of the film to the base material can be obtained. Accordingly, the present invention, by which, after completion of the metal ion bombardment, the base material is coated with a physical vapor-deposited film (namely, a titanium metal film and a DLC film) according to the after-mentioned sputtering method, can be **characterized in that** such a sputtering method may be applied to a series of coating treatments and an arc ion plating method may be applied only to the metal ion bombardment. In order to obtain the above described effect, a high negative pressure from approximately -400 to -1000 V is desirably applied as a bias voltage to the base material during the metal ion bombardment.

Moreover, metal species used in this metal ion bombardment is desirably titanium. Since titanium is highly reactive with oxygen, the oxidized film can be further removed by chemical action, in addition to the above described physical action. Before the titanium metal ion bombardment of the present invention is performed, the conventional argon gas bombardment may be performed. The combined use of the conventional argon gas bombardment with the titanium metal ion bombardment is preferable. In the case of performing the argon gas bombardment, bias voltage applied to the base material during the operation is desirably set at approximately -100 to -600 V

Adhesion of the base material to the titanium metal film is further improved by coating the base material that has previously been treated by the above described titanium metal ion bombardment, with the same metal film as the metal element used in the titanium metal ion bombardment. In the present invention in which the arc ion plating method is employed for the titanium metal ion bombardment, a trace amount of titanium metal element is likely to remain on the surface of the treated base material. Thus, affinity between the base material and the intermediate metal film can be enhanced by forming the intermediate metal film on the base material, using a layer containing the same species of titanium metal, rather than using a metal layer of different species. Accordingly, when titanium is used in the metal ion bombardment, it is desirable to use a titanium film as an intermediate metal film.

After the titanium metal ion bombardment has been performed according to the arc ion plating method, it is preferable that a coating treatment be subsequently performed on the thus treated base material according to a sputtering method in a state in which the base material is maintained in a treating chamber. In the case of a physical vapor deposition apparatus in which a product to be treated (base material) is placed in a chamber and is then subjected to a coating treatment, if the base material is removed from the treating chamber after completion of the metal ion bombardment, the oxidized film and contaminants may be formed on the base material again. Hence, it is desirable to successively perform the above described metal ion bombardment and the subsequent coating treatment according to the sputtering method in a state in which the base material is maintained in the treating chamber. In addition, it is most preferred to perform a series of coating treatments, including the last coating treatment with a DLC film in the above described single chamber. Accordingly, the physical vapor deposition apparatus comprises devices necessary for a series of physical vapor deposition treatments to be performed, including a bombardment, such as an arc ion plating vapor source and a sputtering target.

In the above described series of treatment steps, it is preferable that a temperature rise step be carried out to remove deposits present on the surface of the base material before the coating steps, regardless of the presence or absence of a bombardment. In particular, in the case of sliding components belonging to the technical field of the present invention, the base material of which is prepared by performing machining such as cutting, it is desirable to carry out the above described temperature rise step to remove oil and the like adhering to the surface of the base material. It is important to carry out the temperature rise step at a high temperature of 500°C or higher. In this respect as well, since the base material of the present invention is excellent in terms of resistance to softening at high temperature, it is able to maintain high coating adhesion after the coating treatments.

### [Examples]

As base materials for a surface treatment, there were prepared disk-like test specimens (diameter: 20 mm × thickness: 5 mm) each being made of the ingredients shown in Table 1, which were each adjusted to have a predetermined hardness. Base material No. 3 is JIS-SUJ2. As heat treatment conditions for hardness adjusting, conditions under which all of the base materials could achieve 58 HRC or more were selected. As a result, the tempering temperature for the base materials except for base material Nos. 3 and 15 was higher than 500°C, whereas the tempering temperature of the base material Nos. 3 and 15 was in a low temperature range around 200°C. The plane of each test specimen was polished by mirror mechanical polishing and was then washed using an alkaline ultrasonic wave.

**[Table 1]**

| Base material No. | Ingredient composition (mass %) The numerical value in the parentheses [ ] indicates ppm | | | | | | | | | | | | | | | | | | Remarks |
|---|---|---|---|---|---|---|---|---|---|---|---|---|---|---|---|---|---|---|---|
| | C | Si | Mn | P | S | Ni | Cr | Mo | W | V | Nb | Cu | Al | N | [Mg] | [Ca] | [O] | Fe* | |
| 1 | 0.67 | 1.00 | 0.71 | 0.022 | 0.003 | 0.10 | 9.84 | 2.04 | <0.01 | <0.01 | <0.01 | <0.01 | <0.05 | 0.046 | 1 | <1 | 27 | Balance | Invention |
| 2 | 0.64 | 0.99 | 0.69 | 0.004 | 0.018 | <0.01 | 13.29 | 1.96 | <0.01 | <0.01 | <0.01 | <0.01 | <0.05 | 0.073 | 2 | <1 | 27 | Balance | |
| 3 | 1.03 | 0.25 | 0.25 | 0.020 | <0.001 | 0.10 | 1.45 | <0.01 | <0.01 | <0.01 | <0.01 | <0.01 | <0.05 | 0.003 | <1 | <1 | 18 | Balance | Comparative Example |
| 4 | 0.65 | 1.43 | 0.32 | 0.022 | 0.003 | 0.09 | 9.90 | 1.99 | <0.01 | <0.01 | <0.01 | <0.01 | 0.005 | 0.035 | <1 | <1 | 28 | Balance | |
| 5 | 0.64 | 1.40 | 0.30 | 0.023 | 0.005 | 0.10 | 10.24 | 1.96 | <0.01 | <0.01 | <0.01 | <0.01 | 0.001 | 0.050 | <1 | <1 | 54 | Balance | |
| 6 | 0.65 | 1.03 | 0.30 | 0.024 | 0.004 | 0.11 | 10.20 | 1.98 | <0.01 | <0.01 | <0.01 | <0.01 | 0.002 | 0.049 | <1 | <1 | 34 | Balance | |
| 7 | 0.67 | 1.03 | 0.70 | 0.019 | 0.003 | 0.10 | 9.36 | 0.01 | 4.18 | <0.01 | <0.01 | <0.01 | 0.004 | 0.045 | <1 | <1 | 67 | Balance | |
| 8 | 0.65 | 1.02 | 0.68 | 0.026 | 0.003 | 0.10 | 9.90 | 1.01 | 1.99 | <0.01 | <0.01 | <0.01 | 0.002 | 0.048 | <1 | <1 | 47 | Balance | Invention |
| 9 | 0.67 | 0.99 | 0.70 | 0.024 | 0.002 | 0.11 | 10.01 | 2.01 | <0.01 | 0.04 | 0.002 | 0.02 | 0.020 | 0.042 | <1 | <1 | 10 | Balance | |
| 10 | 0.66 | 1.01 | 0.68 | 0.022 | 0.002 | 0.08 | 10.00 | 2.01 | <0.01 | 0.03 | 0.004 | 0.02 | 0.023 | 0.045 | 1 | <1 | 17 | Balance | |
| 11 | 0.64 | 0.98 | 0.69 | 0.022 | 0.008 | 0.06 | 9.93 | 2.03 | <0.01 | 0.04 | 0.005 | 0.02 | 0.028 | 0.045 | 4 | 1 | 8 | Balance | |
| 12 | 0.64 | 1.05 | 0.67 | 0.020 | 0.006 | 0.07 | 10.02 | 2.00 | <0.01 | 0.04 | 0.002 | 0.02 | 0.027 | 0.047 | 4 | 50 | 64 | Balance | |
| 13 | 0.71 | 0.27 | 0.36 | 0.025 | 0.065 | <0.01 | 7.31 | 0.92 | <0.01 | 0.22 | 0.10 | <0.01 | 0.030 | <0.01 | <1 | <1 | 15 | Balance | Comparative Example |
| 14 | 1.45 | 0.25 | 0.40 | 0.025 | 0.001 | <0.01 | 12.00 | 1.00 | <0.01 | 0.25 | <0.01 | <0.01 | 0.020 | <0.01 | <1 | <1 | 20 | Balance | |
| 15 | 0.65 | 0.35 | 0.70 | 0.030 | 0.005 | <0.01 | 13.00 | <0.01 | <0.01 | <0.01 | <0.01 | <0.01 | 0.020 | <0.01 | <1 | <1 | 20 | Balance | |

The prepared base material Nos. 1 to 15 were placed in an unbalanced magnetron sputtering device having a chamber volume of 1.4 m³ (a space in which a product to be treated was inserted: 0.3 m³), and degassing was then sufficiently carried out by heating them in a vacuum in which the temperature was 773 K and the pressure was 1 × 10⁻³ Pa. Thereafter, a bombardment was carried out using argon gas plasma at a temperature of 723 K at a pressure of 2.0 Pa at a bias voltage from -200 V to -500 V for 5 minutes. Subsequently, on some of the base materials, a metal ion bombardment was performed according to an arc ion plating method using a titanium metal at a temperature of 723K at a bias voltage from -500 V to -800V for 2 minutes.

Following the above described treatment, PVD coating treatments including the coating treatment with the final DLC film were performed on each base material in a state in which the base material was maintained in the chamber, so as to prepare sliding components with evaluation sample Nos. 1 to 30. The coating treatments were carried out according to an unbalanced magnetron sputtering method, using a titanium target and a graphite target, at a predetermined bias voltage at a temperature of 523 K. First, a titanium layer was formed as an intermediate metal film. On the titanium layer, there was formed a mixed gradient film of titanium and carbon, in which titanium content gradually decreased whereas carbon content gradually increased. Then, as an outermost layer, a DLC film was formed. These coating treatments were carried out so that a total film thickness became 1.5 µm. Hardness of the DLC film was approximately 2000 HV when a bias voltage of -50V was applied during the coating treatment, and was approximately 3500 HV when a bias voltage of -200 V was applied during the coating treatment. Bias voltage conditions and film hardness of the sample Nos. 1 to 30 during the above described bombardment and coating treatments are summarized in Table 2.

**[Table 2]**

| Sample No. | Base material No. | Bias voltage (V) *negative pressure | | | | | Film hardness (Hv) | Remarks |
|---|---|---|---|---|---|---|---|---|
| | | Pre-coating treatment | | Coating treatment | | | | |
| | | Ar bombardment | Ti bombardment | Intermediate Ti film | Ti/c gradient film | DLC film | | |
| 1 | 1 | 200 | 800 | 50 | 50 | 50 | 2100 | Invention |
| 2 | | 200 | 500 | 50 | 50 | 50 | 2150 | |
| 3 | | 500 | 500 | 50 | 50 | 50 | 2205 | |
| 4 | | 500 | 500 | 50 | 50 | 200 | 3490 | |
| 5 | 2 | 200 | 500 | 50 | 50 | 50 | 2025 | |
| 6 | 3 | 200 | 500 | 50 | 50 | 50 | 2240 | Comparative Example |
| 7 | 4 | 200 | Not performed | 50 | 50 | 50 | 2200 | |
| 8 | | 200 | 500 | 50 | 50 | 50 | 2200 | |
| 9 | 5 | 200 | Not performed | 50 | 50 | 50 | 2200 | |
| 10 | | 200 | 500 | 50 | 50 | 50 | 2200 | |
| 11 | 6 | 200 | Not performed | 50 | 50 | 50 | 2200 | |
| 12 | | 200 | 500 | 50 | 50 | 50 | 2200 | |
| 13 | 7 | 200 | Not performed | 50 | 50 | 50 | 2200 | |
| 14 | | 200 | 500 | 50 | 50 | 50 | 2200 | |
| 15 | 8 | 200 | Not performed | 50 | 50 | 50 | 2200 | Invention |
| 16 | | 200 | 500 | 50 | 50 | 50 | 2200 | |
| 17 | 9 | 200 | Not performed | 50 | 50 | 50 | 2200 | |
| 18 | | 200 | 500 | 50 | 50 | 50 | 2200 | |
| 19 | 10 | 200 | Not performed | 50 | 50 | 50 | 2200 | |
| 20 | | 200 | 500 | 50 | 50 | 50 | 2200 | |
| 21 | 11 | 200 | Not performed | 50 | 50 | 50 | 2200 | |
| 22 | | 200 | 500 | 50 | 50 | 50 | 2200 | |
| 23 | 12 | 200 | Not performed | 50 | 50 | 50 | 2200 | |
| 24 | | 200 | 500 | 50 | 50 | 50 | 2200 | |
| 25 | 13 | 200 | Not performed | 50 | 50 | 50 | 2200 | Comparative Example |
| 26 | | 200 | 500 | 50 | 50 | 50 | 2200 | |
| 27 | 14 | 200 | Not performed | 50 | 50 | 50 | 2200 | |
| 28 | | 200 | 500 | 50 | 50 | 50 | 2200 | |
| 29 | 15 | 200 | Not performed | 50 | 50 | 50 | 2200 | |
| 30 | | 200 | 500 | 50 | 50 | 50 | 2200 | |

Table 3 shows hardness of the base material of each of the sliding components with sample Nos. 1 to 30 during the above described hardness adjusting (tempering) and after the coating treatment. In addition, an indentation was made on the surface of the film (DLC film) of each sample using a Rockwell hardness tester (AR-10, manufactured by Mitutoyo Corporation) at C-scale. The indentation was observed under an optical microscope, and the degree of cracks generated around the indentation was then evaluated, by which coating adhesion was evaluated.

**[Table 3]**

| Sample No. | Base material No. | Base material hardness (HRC) | | Remarks |
|---|---|---|---|---|
| | | During adjusting (tempered hardness) | After coating treatments | |
| 1 | 1 | 61.5 | 61.5 | |
| 2 | | 61.5 | 61.5 | |
| 3 | | 61.5 | 61.5 | Invention |
| 4 | | 61.5 | 61.5 | |
| 5 | 2 | 60.5 | 60.5 | |
| 6 | 3 | 63.5 | 47.0 | Comparative Example |
| 7 | 4 | 61.5 | 61.5 | |
| 8 | | 61.5 | 61.5 | |
| 9 | 5 | 61.7 | 61.7 | |
| 10 | | 61.7 | 61.5 | |
| 11 | 6 | 61.8 | 61.5 | |
| 12 | | 61.8 | 61.8 | |
| 13 | 7 | 61.6 | 61.6 | |
| 14 | | 61.6 | 61.6 | Invention |
| 15 | 8 | 61.0 | 61.0 | |
| 16 | | 61.0 | 61.0 | |
| 17 | 9 | 61.2 | 61.0 | |
| 18 | | 61.2 | 61.2 | |
| 19 | 10 | 61.3 | 61.5 | |
| 20 | | 61.3 | 61.3 | |
| 21 | 11 | 61.4 | 61.5 | |
| 22 | | 61.4 | 61.4 | |
| 23 | 12 | 61.2 | 61.0 | |
| 24 | | 61.2 | 61.0 | |
| 25 | 13 | 58.5 | 58.5 | |
| 26 | | 58.5 | 58.5 | |
| 27 | 14 | 59.5 | 59.0 | |
| 28 | | 59.5 | 58.0 | Comparative Example |
| 29 | 15 | 59.7 | 59.7 | |
| 30 | | 59.7 | 57.0 | |

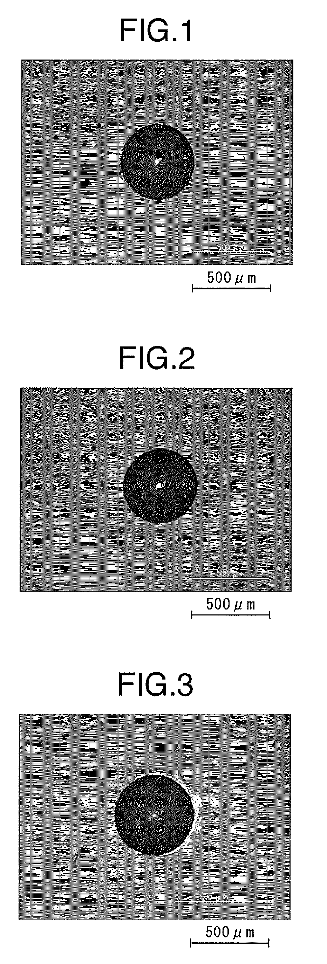

In the case of sample Nos. 1 to 5 (base material Nos. 1 and 2) and samples Nos. 7 to 24 (base material Nos. 4 to 12), for each of which the optimal base material was selected, hardness of the base material after the coating treatments did not substantially decrease as compared with the tempered hardness. Even in the case of performing a metal ion bombardment during which temperature of the base material reached 400°C or higher, the base material maintained a high hardness of 58 HRC or more. In addition, the sample Nos. 1 to 5 and 7 to 24, which were coated with a DLC film having high hardness after they had been coated with an intermediate metal film consisting of titanium, had few cracks generated around the indentation in the above described test, and thus they were excellent in terms of adhesion (Figs. 1 and 2 show microphotographs of indentations made on the films of the sample Nos. 17 and 18, respectively).

On the other hand, in the case of sample No. 6 (base material No. 3) and sample Nos. 25 to 30 (base material Nos. 13 to 15), for each of which a base material that did not satisfy the ingredient composition of the present invention was selected, the base material, on which a metal ion bombardment had not been performed in the series of coating steps, maintained a hardness of 58 HRC or more. However, if the metal ion bombardment was performed, the sample Nos. 6 and 30 made from the base materials Nos. 3 and 15, respectively, adjusted by low temperature tempering, was not able to maintain a hardness of 58 HRC. In particular, in the case of the sample No. 6 made from the base material No. 3 comprising a low amount of Cr and not comprising Mo and W added thereto, hardness of the base material thereof significantly decreased, and many cracks were generated around the above described indentation (Fig. 2).

Even in the case of the sample Nos. 25 to 29, each base material (base material Nos. 13 and 14) of which was able to maintain a hardness of 58 HRC or more, it was difficult for the base material No. 13 comprising a low amount of Cr to stably achieve a hardness of 59 HRC or more, if considering the time point of hardness adjusting. In the case of the base material No. 14, solid solution Cr was lost by formation of a carbide due to addition of excessive C, and thus this base material was poor in terms of toughness and corrosion resistance.

### Industrial Applicability

The present invention can be used for sliding components. Products to which the sliding components are applied are not limited to metals, and the sliding components can also be applied to plastic, lumber, and all products that require characteristics as a hard film. Specifically, the sliding components can be applied to automotive part products such as a valve lifter, a needle or a plunger.

## Claims

1. A surface-coated sliding component having excellent coating adhesion, wherein a surface of a base material comprising, in % by mass, C: 0.5% to 0.8%, Si: 0.1% to 1.5%, Mn: 0.2% to 1.0%, Cr: 8.0% to 13.5%, Mo and/or W: 0.5% to 4.0% (in terms of Mo + 1/2 W), N: 0.01% to 0.1%, and the balance consisting of Fe and impurities, is coated with a hard physical vapor-deposited film, wherein the physical vapor-deposited film comprises a titanium metal film and a diamond-like carbon film further coating the titanium metal film.

2. The surface-coated sliding component having excellent coating adhesion according to claim 1, wherein the base material comprises, in % by mass, Cr: 9.0% to 11.0%.

3. The surface-coated sliding component having excellent coating adhesion according to claim 1 or 2, wherein the base material comprises, in % by mass, one or more of S: 0.1% or less, Ca: 0.1% or less, and Mg: 0.03% or less.

4. The surface-coated sliding component having excellent coating adhesion according to any one of claims 1 to 3, wherein the base material comprises, in % by mass, one or more of V: 1.0% or less, Cu: 0.5% or less, Nb: 0.3% or less, and Ni: 1.0% or less.

5. The surface-coated sliding component having excellent coating adhesion according to any one of claims 1 to 4, wherein the base material has a hardness of 58 HRC or more.

6. The surface-coated sliding component having excellent coating adhesion according to any one of claims 1 to 5, wherein the physical vapor-deposited film comprises the diamond-like carbon film having a surface hardness of 1000 HV or more.

7. The surface-coated sliding component having excellent coating adhesion according to any one of claims 1 to 6, wherein the physical vapor-deposited film comprises, between the titanium metal film and the diamond-like carbon film, a mixed gradient film consisting of titanium and carbon, in which titanium content gradually decreases toward the side of the diamond-like carbon film.

8. A method for producing a surface-coated sliding component having excellent coating adhesion, wherein a surface of a base material comprising, in % by mass, C: 0.5% to 0.8%, Si: 0.1% to 1.5%, Mn: 0.2% to 1.0%, Cr: 8.0% to 13.5%, Mo and/or W: 0.5% to 4.0% (in terms of Mo + 1/2 W), N: 0.01% to 0.1%, and the balance consisting of Fe and impurities, is coated with a hard physical vapor-deposited film,
the method comprises coating the base material with a titanium metal film and then with a diamond-like carbon film as a surface layer according to a sputtering method, whereby the base material is coated with the physical vapor-deposited film comprising the titanium metal film and the diamond-like carbon film.

9. The method for producing a surface-coated sliding component having excellent coating adhesion according to claim 8, wherein, before the base material is coated with the physical vapor-deposited film, an argon gas bombardment is performed on the base material.

10. The method for producing a surface-coated sliding component having excellent coating adhesion according to claim 8, wherein, before the base material is coated with the physical vapor-deposited film, a titanium metal ion bombardment according to an arc ion plating method is performed on the base material, and subsequently, the base material is coated with the titanium metal film and then coated with the diamond-like carbon film as the surface layer so as to form the physical vapor-deposited film comprising the titanium metal film and the diamond-like carbon film.

11. The method for producing a surface-coated sliding component having excellent coating adhesion according to claim 10, wherein an argon gas bombardment is performed on the base material, before the titanium metal ion bombardment is performed thereon.

12. The method for producing a surface-coated sliding component having excellent coating adhesion according to claim 10 or 11, wherein, after completion of the titanium metal ion bombardment, the treated base material is subsequently coated with the physical vapor-deposited film according to the sputtering method while keeping the base material in a treating chamber.

13. The method for producing a surface-coated sliding component having excellent coating adhesion according to any one of claims 8 to 12, wherein the base material comprises, in % by mass, Cr: 9.0% to 11.0%.

14. The method for producing a surface-coated sliding component having excellent coating adhesion according to any one of claims 8 to 13, wherein the base material comprises, in % by mass, one or more of S: 0.1% or less, Ca: 0.1% or less, and Mg: 0.03% or less.

15. The method for producing a surface-coated sliding component having excellent coating adhesion according to any one of claims 8 to 14, wherein the base material comprises, in % by mass, one or more of V: 1.0% or less, Nb: 0.3% or less, Ni: 1.0% or less, and Cu: 0.5% or less.

16. The surface-coated sliding component having excellent coating adhesion according to any one of claims 8 to 15, wherein the base material has an adjustment hardness of 58 HRC or more.

17. The method for producing a surface-coated sliding component having excellent coating adhesion according to any one of claims 8 to 16, wherein the physical vapor-deposited film comprises the diamond-like carbon film having a surface hardness of 1000 HV or more.

18. The method for producing a surface-coated sliding component having excellent coating adhesion according to any one of claims 8 to 17, wherein the coating of the physical vapor-deposited film is performed according to an unbalanced magnetron sputtering method.

19. The method for producing a surface-coated sliding component having excellent coating adhesion according to any one of claims 8 to 18, further comprising coating with a mixed gradient film consisting of titanium and carbon between the titanium metal film and the diamond-like carbon film, the mixed gradient film having titanium content which gradually decreases toward the side of the diamond-like carbon film.
